# EUROPEAN PATENT APPLICATION

(11) **EP 4 199 677 A1**
(43) Date of publication of application: **21.06.2023**
(21) Application number: 21383143.1
(22) Date of filing: 15.12.2021
(51) Int. Cl.: H05K 9/00

(54) **DEVICE FOR COMMON-MODE EMI FILTERING OF AN ELECTRIC SIGNAL**

(71) Applicant: Ikerlan, S. Coop., 20500 Mondragon (ES)
(72) Inventor: TIJERO SERNA, Maria, 20550 ARETXABALETA (ES); MORENO PEREZ, Roberto, 20600 Eibar (ES); BERGANZO RUIZ, Javier, 01010 Vitoria-Gasteiz (ES)
(74) Representative: Igartua, Ismael

(57) **Abstract**

Device for common-mode EMI filtering of an electric signal of an electric circuit of an electrical or electronic appliance, said appliance comprising a conductive surface connected to the reference ground. The device (1) comprises a conductive layer (10) configured for being electrically connected to the electric signal of the appliance, and a dielectric layer (11) which is arranged on said conductive layer (10), the device (1) being configured for being arranged on the conductive surface, such that the dielectric layer (11) is arranged between the conductive layer (10) of the device (1) and the conductive surface of the appliance, a structural capacitor connected to the reference ground being obtained.

## Description

### TECHNICAL FIELD

The present invention relates to a device for common-mode EMI filtering of an electric signal, an electrical or electronic appliance incorporating said device, a method for detecting an electromagnetic emission or immunity problem in which said device is used, and a method for solving an electromagnetic emission or immunity problem in which said device is used.

### PRIOR ART

Electromagnetic compatibility is known as the capacity of any appliance to work satisfactorily in its electromagnetic environment (electromagnetic immunity) without causing electromagnetic disturbances (electromagnetic emission) on anything from that environment.

The use of EMI (electromagnetic interference) filters for filtering an input or output of an appliance to comply with regulations concerning electromagnetic compatibility are known. Namely, common-mode EMI filters for correcting electromagnetic interferences with respect to ground are known. For example, use of a common-mode EMI filter comprising a capacitor connected to ground is known.

EP2687064A1 describes a cooking appliance comprising a capacitor connected to ground for common-mode EMI filtering.

### DISCLOSURE OF THE INVENTION

The object of the invention is to provide a device, an electrical or electronic appliance incorporating said device, a method for detecting an electromagnetic emission or immunity problem in which said device is used, and a method for solving an electromagnetic emission or immunity problem in which said device is used, as defined in the claims.

A first aspect of the invention relates to a device for common-mode EMI filtering of an electric signal of an electric circuit of an electrical or electronic appliance, said appliance comprising a conductive surface connected to a reference ground with respect to which the common-mode electromagnetic disturbances are generated.

The device comprises a conductive layer configured for being electrically connected to the electric signal of the appliance, and a dielectric layer which is arranged on said conductive layer. The device is configured for being arranged on the conductive surface of the appliance, such that the dielectric layer is arranged between the conductive layer of the device and the conductive surface of the appliance, a structural capacitor connected to the reference ground being obtained.

The reference ground is preferably the ground, also referred to as general ground, the appliance comprising a casing or frame comprising the conductive surface, said casing or frame being connected to the ground by means of a cable or by direct contact with the ground. On some occasions when the appliance is not connected to ground, for example in the case of a ship, an aircraft, or a vehicle having rubber wheels, the reference ground will be the general constructive metal frame of the appliance.

A capacitor connected to the reference ground for the EMI filtering of an electric signal of the appliance can be obtained in a simple and cost-effective manner with the device of the invention, using to that end a conductive surface of the appliance which is connected to the reference ground. This solution is particularly advantageous in appliances in which the electric circuit is not connected to the reference ground because the common-mode EMI filter is obtained without having to transfer the reference ground to the circuit.

A second aspect of the invention relates to an electrical or electronic appliance incorporating a device such as the one described in the first aspect of the invention.

A third aspect of the invention relates to a method for detecting an electromagnetic emission or immunity problem in at least one point of an electric circuit of an electrical or electronic appliance.

The method comprises the use of the device described in the first aspect of the invention as a diagnostic kit, the device being arranged on a conductive surface of the metallic frame or casing of the appliance and connecting the conductive layer of the device to at least one point of the electric circuit for detecting the problem.

Therefore, an electromagnetic interference problem can be detected using the device as a diagnostic kit by simply connecting the device to different points of the electric circuit until verifying which one/ones of the signals of the circuit is/are the one/ones having a common-mode electromagnetic interference problem.

A fourth aspect of the invention relates to a method for solving an electromagnetic emission or immunity problem in one point of an electric circuit of an electrical or electronic appliance.

The method comprises the use of the device described in the first aspect of the invention for arranging it on a conductive surface of the appliance and connecting the conductive layer of the device to the point of the electric circuit to solve the problem.

This method allows an electromagnetic interference problem of an electric circuit of the appliance to be solved in a very simple manner by simply connecting the device to said electric circuit.

These and other advantages and features of the invention will become apparent in view of the figures and the detailed description of the invention.

### DESCRIPTION OF THE DRAWINGS

Figure 1 shows a perspective view of a first embodiment of the device according to the invention.
Figure 2 shows a section view of the device of Figure 1.
Figure 3 shows a perspective view of a second embodiment of the device according to the invention.
Figure 4 shows a perspective view of an embodiment of the appliance according to the invention, said appliance comprising a device according to the first embodiment of the invention.
Figure 5 shows a partial section view of the appliance of Figure 4.

### DETAILED DISCLOSURE OF THE INVENTION

A first aspect of the invention relates to a device.

The device is configured for being an integral part of a common-mode EMI filter or for the individual operation thereof as a common-mode EMI filter of an electric signal. Therefore, the device can be used in any electrical or electronic appliance comprising an electric circuit 3 which generates or receives an electric signal which presents common-mode electromagnetic interferences, and a conductive surface 20 connected to the reference ground with respect to which said common-mode electromagnetic disturbances are generated.

The reference ground is preferably the ground, also referred to as general ground. In these cases, the appliance will comprise a casing 2 or frame, which is preferably metallic, comprising the conductive surface 20, said casing 2 or said frame being connected to the ground by means of a cable or by direct contact with the ground. For example, in the case of a home appliance, the casing thereof is generally connected to ground by means of a cable, in contrast with the case of a train, the frame of which is usually connected to ground by direct contact of the wheels to the ground.

In other embodiments in which the appliance is not connected to ground, for example in the case of a ship, an aircraft, or a vehicle having rubber wheels, the reference ground will be the general or outer metallic frame of the appliance, for example in the case of an aircraft the reference ground will be its fuselage.

The device 1, 1' of the invention comprises a conductive layer 10, 10' configured for being electrically connected to the electric signal of the appliance, and a dielectric layer 11, 11' which is arranged on said conductive layer 10, 10'. The dielectric layer 11, 11' preferably covers at least the entire surface of the conductive layer 10, 10' on which it is arranged. Alternatively, the dielectric layer comprises a safety frame protruding with respect to the perimeter of the conductive layer.

The conductive layer 10, 10' can be made of any conductive material or alloy, for example: stainless steel, aluminium, copper, brass, etc.

With respect to the dielectric layer 11, 11', it can be made for example from alumina, aluminium nitride, boron nitride, potassium aluminosilicate (mica), quartz, or sapphire.

The device 1, 1' is configured for being arranged on the conductive surface 20 of the appliance, such that the dielectric layer 11, 11' is arranged between the conductive layer 10, 10' of the device 1, 1' and the conductive surface 20 of the appliance, a structural capacitor connected to the reference ground being obtained.

Therefore, the device 1, 1' allows a conductive surface 20 of the appliance to be utilized to create a structural capacitor, with the added advantage that said conductive surface 20 is connected to the reference ground, and therefore the structural capacitor obtained is connected to the reference ground, such that the device considerably facilitates the possibility of the common-mode filtering of an electric signal of the appliance, particularly in appliances in which the electric circuit does not have a connection to the reference ground.

The device 1, 1' preferably comprises an adhesive layer 12, 12' arranged on the dielectric layer 11, 11', a patch-type device 1, 1' being obtained, the adhesive layer 12, 12' being configured for being adhered to the conductive surface 20 of the appliance. Said adhesive layer 12, 12' preferably covers the entire surface of the dielectric layer 11, 11' on which it is arranged. The adhesive layer can alternatively be formed by discrete points of adhesive which are arranged on the dielectric layer. The patch-type device 1, 1' causes the assembly of the device in the appliance to be very simple since it does not require adjusting the conductive surface 20 of the appliance for the installation thereof.

The device 1, 1' preferably comprises an additional adhesive layer 13, 13' arranged between the conductive layer 10, 10' and the dielectric layer 11, 11' for adhering the conductive layer 10, 10' and the dielectric layer 11, 11' to one another. The additional adhesive layer 13, 13' preferably covers the entire surface of the conductive layer 10, 10' and the dielectric layer 11, 11' between which it is arranged. The additional adhesive layer can alternatively be formed by discrete points of adhesive which are arranged between the conductive layer and the dielectric layer.

The adhesive layer 12, 12' and the additional adhesive layer 13, 13' are preferably made with acrylate glue or acrylic glue.

The conductive layer 10, 10' and the dielectric layer 11, 11' are preferably flexible, such that when the device 1, 1' is arranged on the conductive surface 20 of the appliance, said layers adapt to the shape of said conductive surface 20. This configuration is particularly advantageous in the event that the conductive surface 20 on which the device 1, 1' is arranged presents irregularities because since the conductive layer 10, 10' and the dielectric layer 11, 11' of the device 1, 1' are flexible, they can be adapted to the shape of the conductive surface 20, the conductive layer 10, 10' of the device 1, 1' and the conductive surface 20 of the appliance being arranged with the minimum separation required at all times such that the capacity of the structural capacitor is generated.

The device 1, 1' preferably comprises a connection element 14 comprising a first end electrically connected to the conductive layer 10, 10' and a second end configured for being connected to the electric circuit 3 of the appliance. The connection element 14 can be a continuation of the conductive material itself of the conductive layer 10, 10' of the device 1, 1', a wire of another conductive material, or a twisted cable. Therefore, the only thing the operator has to do to add a capacitor connected to the reference ground to the electric circuit 3 of the appliance is to arrange the device 1, 1' on the conductive surface 20 and connect the second end of the connection element 14 to the point of interest of the electric circuit 3 of the appliance. The first end of the connection element 14 can be connected to the conductive layer 10, 10' by welding, stamping, or any other method known to one skilled in the art which ensures that electric contact between said first end of the connection element 14 and the conductive layer 10, 10' of the device 1, 1' takes place. The second end of the connection element is preferably a stripped cable or wire type element configured for being welded to a point of the electric circuit, electric terminal, clamp, alligator clip, test prod, or any element which assures either a permanent or a provision electric connection for diagnostic work or a temporary solution.

The device may optionally comprise several conductive layers that are distributed and isolated from one another on the same dielectric layer such that several structural capacitors connected to the reference ground can be obtained with a single device. In this case, the device will preferably comprise one connection element for each conductive layer.

A second aspect of the invention relates to an electrical or electronic appliance.

The appliance of the invention comprises a conductive surface 20 connected to the reference ground with respect to which said common-mode electromagnetic disturbances are generated. Said casing 2 or frame is preferably metallic.

As discussed above, the reference ground is preferably the ground. In these cases, the appliance will comprise a casing 2 or frame, which is preferably metallic, comprising the conductive surface 20, said casing 2 or said frame being connected to the ground by means of a cable or by direct contact with the ground. For example, in the case of a home appliance, the casing thereof is generally connected to ground by means of a cable, in contrast with the case of a train, the frame of which is usually connected to ground by direct contact of the wheels to the ground.

In other embodiments in which the appliance is not connected to ground, for example in the case of a ship, an aircraft, or a vehicle having rubber wheels, the reference ground will be the general or outer metallic frame of the appliance, for example in the case of an aircraft the reference ground will be its fuselage.

The appliance also comprises an electric circuit 3 which receives or generates at least one electric signal presenting a common-mode electromagnetic emission or immunity problem and therefore requires a common-mode EMI filter.

Furthermore, the appliance comprises a device 1, 1' such as the one described above.

The device 1, 1' is arranged on the conductive surface 20 of the appliance such that the dielectric layer 11, 11' is arranged between the conductive surface 20 and conductive layer 10, 10' of the device.

The device 1, 1' is connected to the electric circuit 3 of the appliance.

The appliance can be any home appliance, industrial machine, train, elevator, vending machine, recreational machine, automobile, wind turbine, electric charger, inverter, aircraft, ship, etc., provided that said appliance has a conductive surface connected to the reference ground. Furthermore, the electric signal to be filtered can be any type of signal having common-mode electromagnetic interference problems, for example, the 220v power supply signal, a low-voltage signal, a signal from a sensor, etc.

A third aspect of the invention relates to a method for detecting an electromagnetic emission or immunity problem in at least one point of an electric circuit 3 of an electrical or electronic appliance. This method comprises the use of the device 1, 1' described above as a diagnostic kit, the device 1, 1' being arranged on a conductive surface 20 of the casing 2 or frame of the appliance and connecting the conductive layer 10, 10' of the device 1, 1' to said at least one point of the electric circuit 3 for detecting the problem, observing the behavior in electromagnetic emission or immunity with the inclusion of the structural capacitor.

The diagnostic kit may comprise a plurality of devices 1, 1', the conductive layer 10, 10' of each of said devices 1, 1' comprising different sizes, such that the kit allows structural capacitors of a different capacity to be obtained based on the chosen device 1, 1', the capacity of the structural capacitor being greater the larger the area covered by the conductive layer 10, 10' is, provided that the material of the dielectric layer 11, 11' and the thickness thereof are maintained. The capacity of the structural capacitor depends on the dielectric constant of the dielectric material, as well as on the thickness of said dielectric layer 11, 11', the capacity decreasing as increases the of the dielectric layer 11, 11' thickness.

A fourth aspect of the invention relates to a method for solving an electromagnetic emission or immunity problem in one point of an electric circuit 3 of an electrical or electronic appliance. This method comprises the use of the device 1, 1' described above for arranging it on a conductive surface 20 of the casing 2 or the frame of the appliance and connecting the conductive layer 10, 10' of the device 1, 1' to said point of the electric circuit 3 to solve the problem.

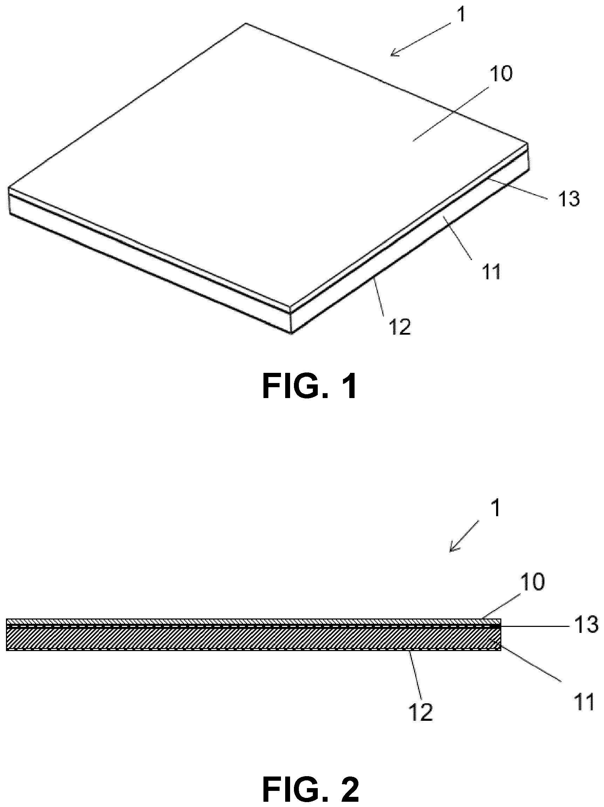

Figures 1 and 2 show a first embodiment of a device 1 for common-mode EMI filtering of an electric signal of an electrical or electronic appliance.

In this first embodiment, the device 1 comprises a conductive layer 10 configured for being electrically connected to the electric signal of the appliance, and a dielectric layer 11 which is arranged on said conductive layer 10. The dielectric layer 11 covers the entire surface of the conductive layer 10 on which it is arranged.

In this first embodiment, the device 1 also comprises an adhesive layer 12 arranged on the dielectric layer 11, a patch-type device 1 being obtained, the adhesive layer 12 being configured for being adhered to a conductive surface 20 of an appliance. Said adhesive layer 12 covers the entire surface of the dielectric layer 11 on which it is arranged.

In this first embodiment, the device 1 also comprises an additional adhesive layer 13 arranged between the conductive layer 10 and the dielectric layer 11 for adhering the conductive layer 10 and the dielectric layer 11 to one another. The additional adhesive layer 13 covers the entire surface of the conductive layer 10 and the dielectric layer 11 on which it is arranged.

The conductive layer 10 and the dielectric layer 11 are preferably flexible, such that when the device 1 is arranged on the conductive surface 20 of the appliance they adapt to the shape of said conductive surface 20.

The device 1 comprises a connection element 14 (not shown in Figures 1 and 2) comprising a first end electrically connected to the conductive layer 10 and a second end configured for being connected to the electric circuit 3 of the appliance.

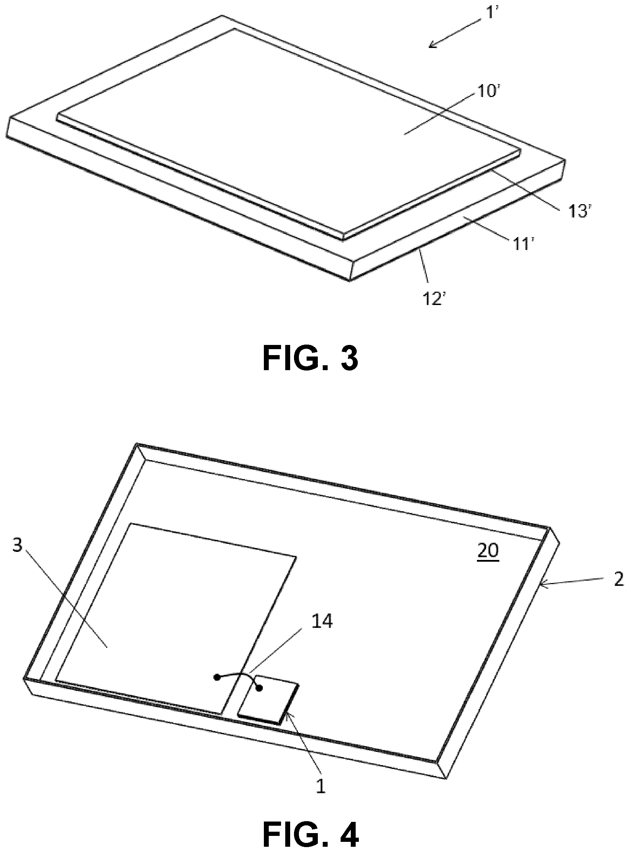

Figure 3 shows a second embodiment of the device. The device of the second embodiment differs from the device of the first embodiment in that the dielectric layer 11' comprises a safety frame protruding with respect to the perimeter of the conductive layer 10'. The fact that the dielectric layer 11' comprises the safety frame provides greater insulation between the conductive layer 10' and the conductive surface 20 of the appliance, and therefore added safety to prevent a direct electrical connection between said conductive layer 10' and said conductive surface 20 from occurring. The insulating frame will be defined based on the insulation needed for the specific appliance, taking into account the applicable regulations and appliance design and construction experience, where different insulating frames can be made based on the sector, working voltages, degrees of contamination, etc. For the design of the necessary insulation, the following distances between the conductive layer 10' and the conductive surface will be taken into account: distance through the insulation (thickness of the dielectric layer 11'), distance in the air, and distance along the surface of the dielectric layer 11'.

The remaining features are similar to those of the first embodiment, and describing them again is considered unnecessary.

Figure 4 partially shows an appliance according to an embodiment of the invention, said appliance being a cooking hob. The appliance comprises the casing 2, which is preferably metallic, comprising a conductive surface 20 connected to ground.

The appliance of this embodiment also comprises an electric circuit 3 which is arranged in the casing 2 and which receives or generates at least an electric signal having a common-mode electromagnetic disturbance problem and therefore requiring a common-mode EMI filter.

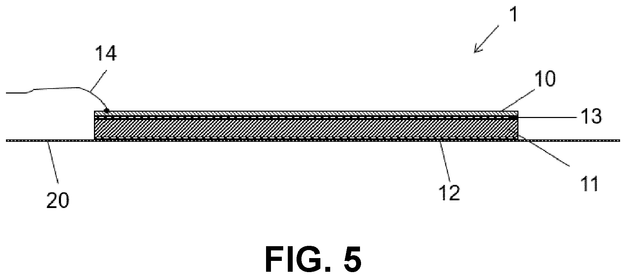

The appliance also comprises a device 1 according to the first embodiment described above, said device being adhered to the conductive surface 20 of the casing 2 of the appliance. As shown in Figure 5, the adhesive layer 12 is adhered to the conductive surface 20 of the casing, the dielectric layer 11 being arranged between the conductive layer 10 of the device 1 and the conductive surface 20 of the appliance, a structural capacitor connected to ground being obtained. The conductive layer 10 is connected to the electric circuit 3 by means of the second end of the connection element 14 of the device 1.

## Claims

1. Device for common-mode EMI filtering of an electric signal of an electric circuit (3) of an electrical or electronic appliance, said appliance comprising a conductive surface (20) connected to a reference ground with respect to which are generated the common-mode electromagnetic disturbances, **characterized in that** the device (1, 1') comprises
- a conductive layer (10, 10') configured for being electrically connected to the electric signal of the appliance, and
- a dielectric layer (11, 11') which is arranged on said conductive layer (10, 10'), the device (1, 1') being configured for being arranged on the conductive surface (20), such that the dielectric layer (11, 11') is arranged between the conductive layer (10, 10') of the device (1, 1') and the conductive surface (20) of the appliance, a structural capacitor connected to the reference ground being obtained.

2. Device according to claim 1, comprising an adhesive layer (12, 12') arranged on the dielectric layer (11, 11'), a patch-type device (1, 1') being obtained, the adhesive layer (12, 12') being configured for being adhered to the conductive surface (20) of the appliance.

3. Device according to claim 1 or 2, wherein the conductive layer (10, 10') and the dielectric layer (11, 11') are flexible, such that when the device (1, 1') is arranged on the conductive surface (20) of the appliance they adapt to the shape of said conductive surface (20).

4. Device according to any of claims 1 to 3, comprising a connection element (14) comprising a first end electrically connected to the conductive layer (10, 10') and a second end configured for being connected to the electric circuit (3) of the appliance.

5. Device according to any of claims 1 to 4, wherein the dielectric layer (11, 11') covers at least the entire surface of the conductive layer (10, 10') on which it is arranged.

6. Device according to claim 5, wherein the dielectric layer comprises a safety frame protruding with respect to the perimeter of the conductive layer.

7. Device according to any of claims 1 to 6, comprising an additional adhesive layer (13, 13') arranged in the conductive layer (10, 10') and the dielectric layer (11, 11') for adhering said conductive layer (10, 10') and said dielectric layer (11, 11') to one another.

8. Electrical or electronic appliance comprising a device (1, 1') according to any of the preceding claims.

9. Appliance according to claim 8, wherein the appliance is a cooking appliance, the electric signal to be filtered preferably being the supply voltage to which the cooking appliance is connected.

10. Appliance according to claim 9, wherein the electric appliance is a cooking hob.

11. Method for detecting an electromagnetic emission or immunity problem in at least one point of an electric circuit (3) of an electrical or electronic appliance, **characterized in that** it comprises the use of the device (1, 1') according to any of claims 1 to 7 as a diagnostic kit, the device (1, 1') being arranged on a conductive surface (20) of the appliance and connecting the conductive layer (10, 10') of the device (1, 1') to said at least one point of the electric circuit (3) for detecting the problem.

12. Method according to claim 11, wherein the diagnostic kit comprises a plurality of devices (1, 1') configured for obtaining structural capacitors of different capacities, the method comprising the use of different devices (1, 1') until detecting the electromagnetic emission or immunity problem in at least one point of an electric circuit (3) of the appliance.

13. Method for solving an electromagnetic emission or immunity problem in one point of an electric circuit (3) of an electrical or electronic appliance, **characterized in that** it comprises the use of the device (1, 1') according to any of claims 1 to 7 for arranging it on a conductive surface (20) of the appliance and connecting the conductive layer (10, 10') of the device (1, 1') to said point of the electric circuit (3) to solve the problem.
